# DEMANDE DE BREVET EUROPEEN

(11) **EP 2 927 972 A1**
(43) Date de publication de la demande: **07.10.2015**
(21) Numéro de dépôt: 15248035.6
(22) Date de dépôt: 03.04.2015
(51) Int. Cl.: H01L 35/10, H01L 35/32

(54) **DISPOSITIF THERMOÉLECTRIQUE À CONNECTEUR ISOLÉ ET ÉLÉMENT DE LIGNE D'ÉCHAPPEMENT COMPORTANT UN TEL DISPOSITIF**

(30) Priorité: 03.04.2014 FR 1452988
(71) Demandeur: VALEO SYSTEMES THERMIQUES, 78320 Le Mesnil Saint-Denis (FR)
(72) Inventeur: Bauerheim, Alain, 51140 JONCHERY-SUR-VESLE (FR); Boisselle, Patrick, 53000 Laval (FR)
(74) Mandataire: Metz, Gaëlle

(57) **Abrégé**

L'invention concerne un dispositif thermoélectrique comportant un premier circuit (14), parcouru par un premier fluide et destiné à être raccordé à une chambre de circulation du premier fluide, un second circuit (16) parcouru par un second fluide, et au moins un module (18) d'éléments thermoélectriques (24P, 24N) permettant la génération d'un courant électrique à partir d'un gradient de température appliqué entre des première et seconde faces actives (26, 28) desdits éléments thermoélectrique (24P, 24N), respectivement en relation d'échange thermique avec lesdits premier et second circuits, ledit second circuit (16) comportant au moins une chambre (22) de circulation du second fluide, ledit dispositif comportant en outre au moins un connecteur (36), relié électriquement audit module (18), pour permettre la connexion électrique dudit module (18) extérieurement audit dispositif, ledit connecteur (36) étant configuré pour passer entre lesdites chambres de circulation des premier et second fluides.

## Description

La présente invention concerne un dispositif thermoélectrique, notamment pour véhicule automobile. Il pourra s'agir, par exemple, d'un élément de ligne d'échappement d'un véhicule automobile, en particulier pour un système de recyclage de gaz d'échappement ou EGR (Exhaust Gas Recycling).

La présente invention concerne tout particulièrement un élément de ligne d'échappement d'un véhicule automobile formant également refroidisseur de gaz d'échappement.

Il a déjà été proposé des modules thermoélectriques utilisant des éléments, dits thermoélectriques, permettant de générer un courant électrique en présence d'un gradient de température entre deux de leurs faces opposées selon le phénomène connu sous le nom "d'effet Seebeck".

Il a en particulier déjà été envisagé de disposer de tels modules dans dans une chambre de circulation d'un fluide caloporteur d'un circuit de refroidissement traversé par des conduits de passage des gaz d'échappement d'un moteur. Les éléments thermoélectriques des modules sont pris en sandwich entre les conduits et la chambre de façon à être soumis à un gradient de température provenant de la différence de température entre les gaz d'échappement, chauds, et le fluide de refroidissement, froid.

Les modules thermoélectriques sont reliés à au moins un connecteur électrique, faisant saillie hors de la chambre pour permettre la connexion électrique du module thermoélectrique extérieurement.

Un problème se pose quant à la réalisation pratique de ce connecteur et quand à son implantation en sortie de la chambre.

En effet, le connecteur est soumis à d'importantes contraintes thermiques résultant de la proximité des conduits de gaz d'échappement dont la chaleur peut faire fondre toute soudure à basse température qui serait réalisée dans cette zone, ou tout fil agencé dans cette zone.

Par ailleurs, il convient d'assurer une isolation du connecteur vis-à-vis de la première chambre, afin d'éviter tout contact entre ledit connecteur et le fluide de refroidissement, ledit fluide pouvant être à l'origine de courts-circuits.

Pour éviter tout risque de dysfonctionnement du connecteur, l'invention propose un dispositif thermoélectrique comportant un connecteur qui est isolé du fluide de refroidissement et qui est isolé thermiquement de la chaleur produite par les gaz d'échappement.

L'invention concerne ainsi un dispositif thermoélectrique comportant un premier circuit, parcouru par un premier fluide et destiné à être raccordé à une chambre de passage dudit premier fluide, un second circuit parcouru par un second fluide, et au moins un module d'éléments thermoélectriques permettant la génération d'un courant électrique à partir d'un gradient de température appliqué entre des première et seconde faces actives desdits éléments thermoélectriques, respectivement en relation d'échange thermique avec lesdits premier et second circuits, ledit second circuit comportant au moins une chambre de circulation du second fluide, ledit dispositif comportant en outre au moins un connecteur, relié électriquement audit module, pour permettre la connexion électrique dudit module extérieurement audit dispositif.

Selon l'invention, ledit connecteur est configuré pour passer entre lesdites chambres de circulation des premier et second fluides.

En faisant passer ledit connecteur entre lesdites chambres, on lui permet d'éviter d'avoir à traverser le second fluide tout en le maintenant à distance du premier fluide. On le protège de la sorte de l'éventuelle chaleur de ce dernier. On optimise en outre l'emplacement du connecteur par rapport au module.

Selon d'autres caractéristiques de l'invention qui pourront être prises ensemble ou en combinaison :
- ladite chambre de circulation du premier fluide est une chambre collectrice et/ou de distribution dudit premier fluide,
- ledit premier circuit est au moins partiellement logé dans ladite chambre de circulation du second fluide,
- ledit connecteur traverse de manière étanche une paroi de la chambre de circulation du second fluide,
- ledit connecteur comprend une partie intermédiaire, dite d'isolation, en contact avec une surface de ladite paroi, en dehors de ladite chambre de circulation du second fluide,
- ledit dispositif est configuré pour que ladite partie d'isolation soit thermiquement isolée de ladite chambre de circulation du premier fluide,
- ledit dispositif est configuré pour que ladite partie d'isolation soit thermiquement isolé dudit premier circuit,
- ladite paroi de la chambre de circulation du second fluide comprend un orifice de passage dudit connecteur,
- ledit orifice de passage dudit connecteur est également traversé par ledit premier circuit,
- ledit dispositif comprend une lame d'air traversée par ladite partie d'isolation pour l'isoler thermiquement de ladite chambre de circulation du premier fluide et/ou dudit premier circuit,
- ledit premier circuit comporte au moins un premier conduit de circulation du premier fluide en relation d'échange thermique avec au moins l'une des premières faces actives des éléments thermoélectriques,
- ladite chambre de circulation du second fluide est agencée autour du premier conduit, ladite chambre de circulation du second fluide étant apte à permettre la circulation du second fluide en relation d'échange thermique avec la seconde face active des éléments thermoélectriques,
- ledit dispositif comporte au moins un premier boîtier comprenant un corps comportant au moins une cavité orientée sensiblement suivant une direction axiale (A) du premier conduit, ledit corps recevant la chambre de circulation du second fluide et entourant le premier conduit,
- ledit corps comporte une ouverture, fermée de manière étanche par une plaque de fermeture qui est traversée par le premier conduit,
- la paroi de la chambre de circulation du second fluide comprend une plaque d'isolation qui est pincée entre un pourtour de l'ouverture du corps et la plaque de fermeture,
- ladite plaque d'isolation reçoit au moins une partie de la partie intermédiaire du connecteur dans son épaisseur,
- l'extrémité du connecteur fait saillie hors du premier boîtier sensiblement dans le plan de ladite plaque d'isolation,
- des joints d'étanchéité correspondants au pourtour de l'ouverture du corps et à un pourtour correspondant de la plaque de fermeture sont interposés entre l'ouverture du corps et la plaque d'isolation d'une part et entre la plaque d'isolation et la plaque de fermeture d'autre part,
- au moins le joint d'étanchéité entre la plaque d'isolation et la plaque de fermeture est déformable élastiquement en compression, ledit joint étant d'une épaisseur (e) déterminée pour délimiter entre la plaque d'isolation et la plaque de fermeture un jeu apte à absorber la dilatation de chaque premier conduit,
- lesdits éléments thermoélectriques sont annulaires et ledit module est tubulaire,
- ledit connecteur est relié électriquement à au moins une bague annulaire du module, ladite bague permettant la conduction du courant électrique généré par le module,
- le connecteur comporte une partie de liaison qui est agencée axialement entre la bague annulaire et la partie intermédiaire du connecteur et qui est isolée du premier conduit par l'intermédiaire d'une couche (C) d'air,
- la partie de liaison est tubulaire et elle délimite radialement autour du premier conduit et axialement entre l'un des éléments thermoélectriques terminant axialement le module et la plaque de fermeture une chambre isolante remplie d'air comportant la couche (C) d'air,
- la partie de liaison est venue de matière avec la bague annulaire du module,
- la bague annulaire du module est située au niveau d'une face annulaire extérieure dudit élément thermoélectrique terminant axialement ledit module,
- la partie de liaison du connecteur est reçue dans un alésage complémentaire de la plaque d'isolation et elle s'étend au moins jusqu'à une face de la plaque d'isolation tournée vers la plaque de fermeture, ledit alésage correspondant à l'orifice de passage du connecteur dans la paroi de la chambre de circulation du second fluide,
- la plaque d'isolation est réalisée en un matériau plastique, notamment du polyamide 6.6, et la partie intermédiaire du connecteur est au moins partiellement noyée par surmoulage dans le matériau plastique de la plaque d'isolation,
- la partie intermédiaire du connecteur est soudée à la partie de liaison du connecteur,
- ledit connecteur comporte au moins une cosse faisant saillie hors du premier boîtier pour permettre la connexion électrique dudit module extérieurement au premier boîtier,
- ladite cosse est venue de matière avec la partie intermédiaire.
- ledit module comporte au moins une bague annulaire électriquement et thermiquement conductrice qui est agencée au contact de chaque face annulaire active et au moins une gaine électriquement isolante et thermiquement conductrice qui est interposée entre la chambre de circulation du second fluide et la seconde face annulaire active des éléments thermoélectriques,
- le connecteur est isolé de la chambre de circulation du second fluide par l'intermédiaire d'un joint annulaire qui est interposé entre une face d'épaulement formée à l'extrémité de ladite gaine et la plaque d'isolation.

Selon un aspect de l'invention, ledit dispositif pourra comprendre une pluralité de dits modules. La plaque de fermeture du premier boîtier pourra alors être traversée par des extrémités d'entrée des premiers conduits desdits premiers circuits, associés à chaque module.

Lesdits modules sont reliés, par exemple, suivant un accouplement électrique en série, deux modules thermoélectriques de début et de fin d'accouplement comportant chacun un dit connecteur à l'une de leur extrémité destinée à être tournée vers ladite chambre de circulation du premier fluide, en particulier, vers ladite plaque de fermeture.

Selon un premier mode de réalisation de cet aspect de l'invention :
- le corps du premier boîtier reçoit une pluralité de seconds conduits,
- les seconds conduits sont agencés parallèlement aux premiers conduits,
- les seconds conduits traversent la chambre de circulation du second fluide,
- des extrémités d'entrée des second conduits sont reliées à des extrémités de sortie des premiers conduits opposées à la plaque de fermeture par l'intermédiaire d'une chambre de distribution du premier fluide,
- des extrémités de sortie des seconds conduits traversent la plaque de fermeture,
- lesdits seconds conduits sont configurés en un faisceau d'échange de chaleur entre les premier et second fluides.

Selon un autre mode de réalisation de cet aspect de l'invention :
- le premier boîtier est accouplé à son extrémité opposée à la plaque de fermeture avec un second boîtier,
- ledit second boîtier reçoit une pluralité de seconds conduits agencés au sein d'une seconde chambre de circulation du second fluide,
- des extrémités d'entrée desdits seconds conduits sont reliées à des extrémités de sortie des premiers conduits opposées à la plaque de fermeture du premier boîtier par l'intermédiaire d'une chambre intermédiaire de distribution du premier fluide,
- lesdits seconds conduits sont configurés en un faisceau d'échange de chaleur entre le premier et le second fluide,
- la chambre intermédiaire de distribution du premier fluide est formée dans un boîtier intermédiaire qui est interposé entre les premier et second boîtiers.

L'invention concerne également un élément de ligne d'échappement d'un véhicule automobile comprenant un dispositif tel que décrit plus haut, ledit premier fluide étant formé de gaz d'échappement, notamment de gaz d'échappement recirculés. Ledit second fluide pourra alors être un fluide de refroidissement.

D'autres caractéristiques et avantages de l'invention apparaîtront à la lecture de la description détaillée qui suit pour la compréhension de laquelle on se reportera aux dessins annexés dans lesquels :
- la figure 1 est une vue en coupe d'un élément de ligne d'échappement selon un premier mode de réalisation de l'invention ;
- la figure 2 est une vue en perspective d'un élément de ligne d'échappement selon un second mode de réalisation de l'invention ;
- la figure 3 est une vue en coupe avec arrachement illustrant le détail d'un module thermoélectrique pour un élément de ligne d'échappement selon l'une des figures 1 ou 2 ;
- la figure 4 est une vue de détail en coupe de l'extrémité d'un module thermoélectrique et d'un connecteur associé pour un élément de ligne d'échappement selon l'une des figures 1 ou 2.

Dans la description qui va suivre, des chiffres de référence identiques désignent des pièces identiques ou ayant des fonctions similaires.

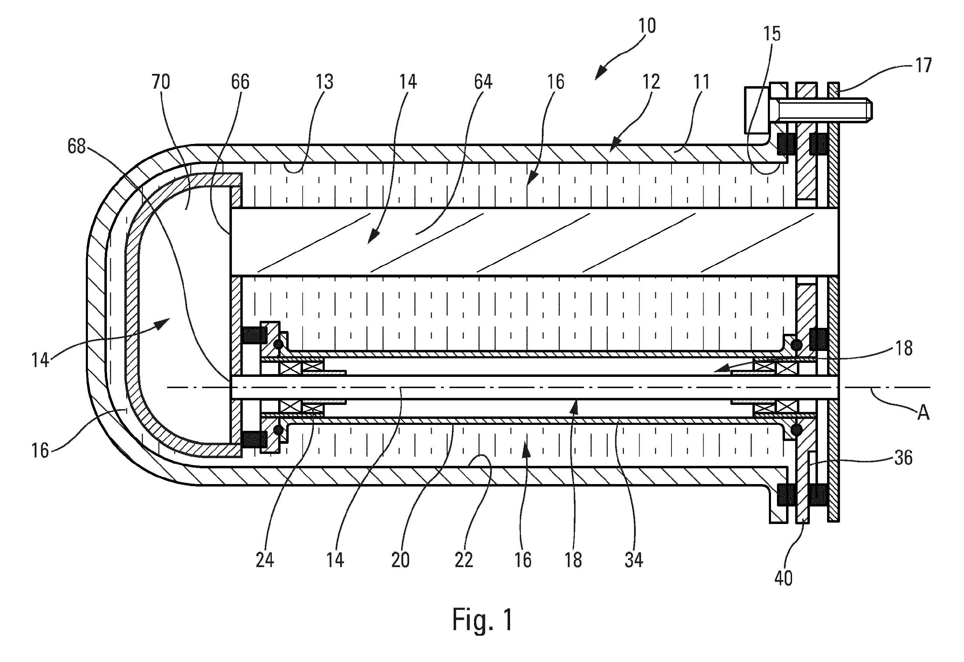

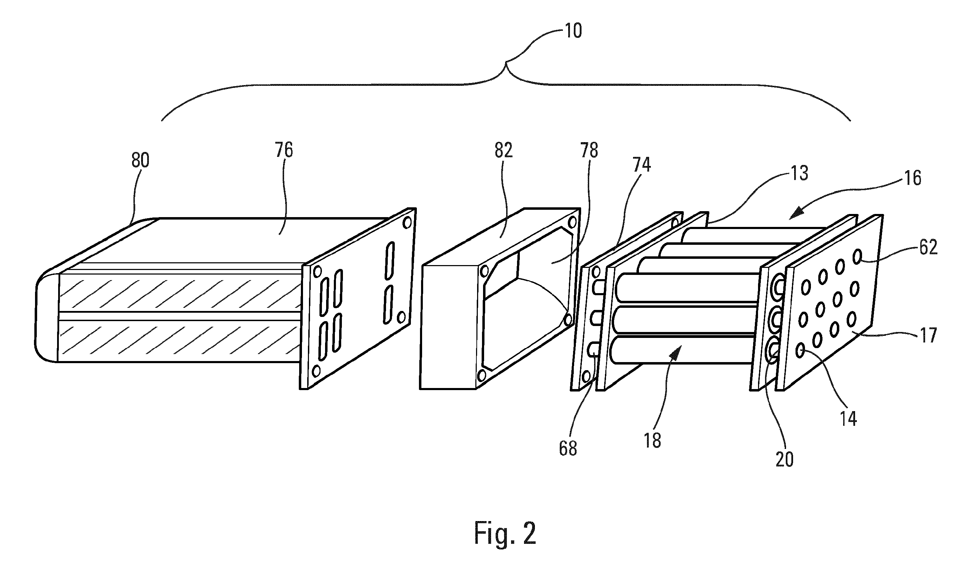

On a représenté aux figures 1 et 2 des premier et second modes de réalisation d'un dispositif thermoélectrique selon l'invention, en particulier d'un élément 10 de ligne d'échappement de véhicule automobile.

Comme l'illustre par exemple la figure 1, l'élément 10 comporte au moins un premier boîtier 12 qui reçoit un premier circuit 14 parcouru par des gaz d'échappement, un second circuit 16 parcouru par un fluide de refroidissement, et au moins un module thermoélectrique 18 tubulaire, apte à être connecté extérieurement à la ligne d'échappement extérieurement au premier boîtier 12.

Le module thermoélectrique 18 est agencé entre le premier circuit 14, dit chaud, dans lequel circulent les gaz d'échappement d'un moteur et le second circuit 16, dit froid, parcouru par le fluide de refroidissement

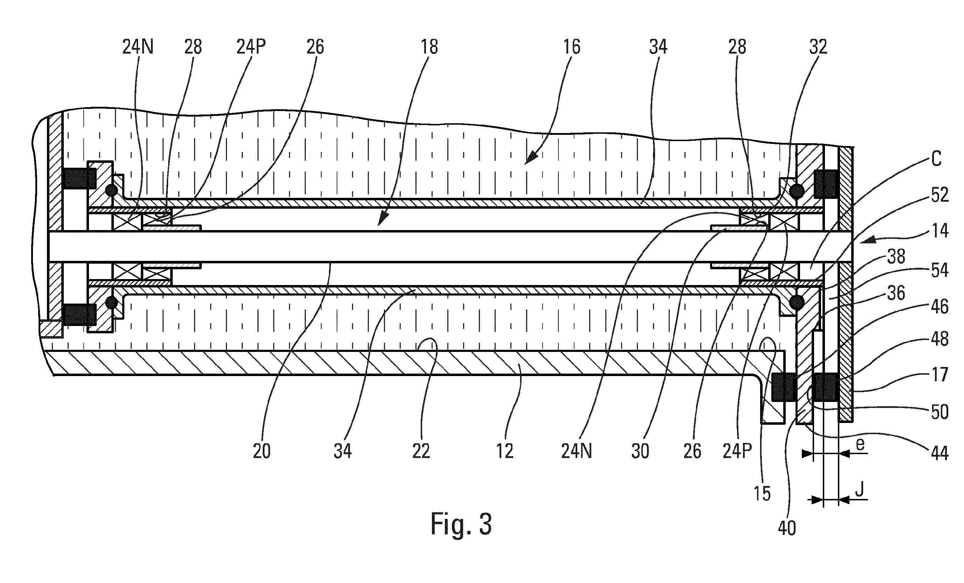

A cet effet, comme l'illustrent les figures 1 et 3, le premier circuit 14 comporte au moins un premier conduit 20 de gaz d'échappement et le second circuit 16 comporte une première chambre 22 de fluide de refroidissement qui est agencée au moins autour du premier conduit 20 de gaz.

Ledit premier circuit 14, en particulier le ou lesdits conduits 20, sont destinés à être raccordés à une chambre de circulation, en particulier une chambre de distribution desdits gaz d'échappement, non-illustrée mais venant au dessus du dispositif sur les figures.

Comme l'illustre plus particulièrement la figure 3, le module thermoélectrique 18 comprend au moins un élément thermoélectrique 24P ou 24N.

De préférence le module thermoélectrique 18 comporte une pluralité d'éléments thermoélectriques 24P, 24N annulaires susceptibles de générer un courant électrique sous l'action d'un gradient de température exercé entre des faces actives annulaires 26, 28 desdits éléments 24P, 24N.

De tels éléments thermoélectriques 24P, 24N fonctionnent de manière connue selon l'effet Seebeck, en permettant de créer un courant électrique dans une charge connectée entre les faces 26, 28 soumises au gradient de température. De tels éléments sont constitués, par exemple, de Bismuth et de Tellurium (Bi₂Te₃).

Les éléments thermoélectriques 24P, 24N sont, pour une première partie, des éléments 24P, d'un premier type, dit P, permettant d'établir une différence de potentiel électrique dans un sens, dit positif, lorsqu'ils sont soumis à un gradient de température donné, et, pour l'autre partie, des éléments 24N d'un second type, dit N, permettant la création d'une différence de potentiel électrique dans un sens opposé, dit négatif, lorsqu'ils sont soumis au même gradient de température. Lesdits éléments thermoélectriques 24P, 24N sont, par exemple, groupés par paire, chaque paire étant formée d'un élément thermoélectrique 24P de type P et d'un élément thermoélectrique 24N de type N.

Les faces annulaires 26, 28 sont situées sur la périphérie intérieure et extérieure de la forme annulaire de chaque élément thermoélectrique 24P ou 24N de sorte que chaque élément thermoélectrique 24P, 24N présente une face active intérieure 26 et une face active extérieure 28.

Le module thermoélectrique 18 comporte au moins une bague annulaire 30, 32 électriquement et thermiquement conductrice qui est agencée au contact de chaque face annulaire active. Plus particulièrement, une bague annulaire intérieure 30 est agencée au contact des faces intérieures 26 de deux éléments 24P, 24N consécutifs d'une même paire, et une bague annulaire extérieure 32 est agencée au contact des faces extérieures de deux éléments 24N, 24P consécutifs de deux paires voisines, comme représenté à la figure 3.

Le module thermoélectrique 18 est ainsi configuré pour permettre une circulation de courant entre les faces actives intérieures 26 des éléments thermoélectriques 24P, 24N d'une même paire grâce aux bagues annulaires internes 30 et une circulation de courant entre les faces actives extérieures 28 de deux éléments thermoélectriques voisins 24P, 24N appartenant à deux paires différentes grâce aux bagues externes annulaires 32. On établit de la sorte une circulation de courant en série d'un élément thermoélectrique à l'autre, en faisant alterner les éléments thermoélectriques 24P, 24N de type P et de type N.

Le module thermoélectrique 18 comporte par ailleurs une gaine 34 électriquement isolante et thermiquement conductrice qui est interposée entre la première chambre 22 de fluide de refroidissement et la seconde face annulaire active 28 des éléments thermoélectriques 24P, 24N.

Plus particulièrement, la gaine 34 est hermétique et entoure les éléments thermoélectriques 24P, 24N et les bagues extérieures 32. La gaine 34 est ainsi disposée du côté des secondes faces actives extérieures 28 des éléments thermoélectriques 18. La gaine 34 empêche tout contact électrique du fluide de refroidissement avec les éléments thermoélectriques 24P, 24N, tout en étant thermiquement conductrice. Elle permet ainsi de fournir aux éléments thermoélectriques 24P, 24N, notamment par l'intermédiaire des bagues externes 32, la source froide nécessaire pour fournir le gradient de température dont les éléments thermoélectriques 24P, 24N ont besoin pour générer de l'électricité.

Dans cette configuration, il est nécessaire pour pouvoir avoir accès au courant électrique produit par le ou les modules thermoélectriques 18, de disposer d'au moins un connecteur, relié électriquement à au moins une des bague annulaires 30, 32 du module thermoélectrique 18, ce connecteur comportant au moins une cosse faisant saillie hors du premier boîtier 12 pour permettre la connexion électrique du module thermoélectrique 18 tubulaire considéré, extérieurement au premier boîtier 12.

En pratique, dans une configuration selon laquelle le boîtier 12 reçoit une pluralité de modules thermoélectriques 18, il est nécessaire de disposer de deux connecteurs, reliés électriquement à au moins une des bagues annulaires 30, 32 de deux modules thermoélectriques 18 reliés électriquement l'un à l'autre, soit directement, soit par l'intermédiaire d'autres modules thermoélectriques 18 branchés en série.

Un problème se pose quant à la réalisation pratique de ce type de connecteur et quant à son implantation en sortie du premier boîtier 12.

En effet, le connecteur est soumis à d'importantes contraintes thermiques résultant de la proximité du premier conduit 20 de gaz d'échappement dont la chaleur peut faire fondre à basse température toute soudure qui serait réalisée dans cette zone, ou tout fil agencé dans cette zone.

Par ailleurs le connecteur est logiquement agencé à proximité de la première chambre 16 de fluide de refroidissement, ce qui implique d'assurer une isolation dudit connecteur vis-à-vis de la première chambre 16, afin d'éviter tout contact entre ledit connecteur et le fluide de refroidissement, ledit fluide pouvant être à l'origine de courts-circuits.

Pour éviter tout risque de dysfonctionnement du connecteur, l'invention propose un élément 10 de ligne d'échappement comportant un connecteur 36 qui est isolé du fluide de refroidissement et qui est isolé thermiquement de la chaleur produite par les gaz d'échappement.

Dans ce but, l'invention propose un élément du type décrit précédemment, dans lequel le connecteur 36 est configuré pour passer entre ladite première chambre 22 de fluide de refroidissement et ladite chambre de distribution des gaz d'échappement. Il est de la sorte isolé de la première chambre 22 de fluide de refroidissement et de la chambre de distribution des gaz d'échappement. Il pourra en outre être avantageusement isolé du premier conduit 20 de gaz d'échappement.

Préférentiellement, ledit connecteur 36 traverse de manière étanche une paroi 40 de la première chambre de circulation de fluide de refroidissement. Il comprend une partie intermédiaire 38, dite d'isolation, en dehors de ladite première chambre de circulation 22 du fluide de refroidissement. Ladite partie de liaison est ici en contact avec une surface de ladite paroi 40.

Comme l'illustre la figure 1, qui concerne spécifiquement un premier mode de réalisation de l'invention, et plus généralement la figure 3 qui concerne le premier et un second mode de réalisation de l'invention, le premier boîtier 12 comporte un corps 11 comportant au moins une cavité 13 orientée sensiblement suivant la direction axiale "A" du premier conduit, qui reçoit la première chambre 22 de fluide de refroidissement entourant le premier conduit 20.

Une ouverture 15 du corps 11 est fermée de manière étanche par une plaque 17 de fermeture qui est traversée par le premier conduit 20.

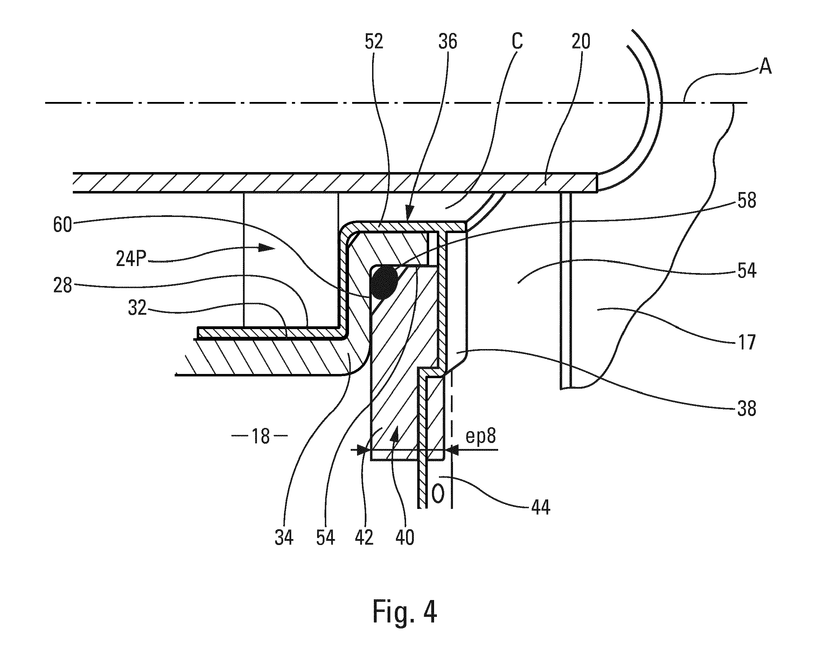

Conformément à l'invention, comme l'illustre la figure 3, la paroi 40 de la première chambre de circulation de fluide de refroidissement est ici constituée d'une plaque d'isolation 40 qui est pincée entre un pourtour de l'ouverture 15 du corps 11 et la plaque 17 de fermeture. Comme l'illustre plus en détail la figure 4, la plaque d'isolation 40 reçoit la partie intermédiaire 38 du connecteur 36 dans son épaisseur 42, au moins sur une portion de sa longueur. Une extrémité 44 du connecteur fait saillie hors du premier boîtier sensiblement dans le plan de ladite plaque 40 d'isolation.

Comme l'illustre la figure 3, pour isoler la plaque d'isolation 40 de la chaleur qui pourrait être transmise par le corps 11 et la plaque 17 de fermeture du boîtier 12, des joints d'étanchéité 46, 48 correspondants au pourtour de l'ouverture 15 du corps 11 et à un pourtour correspondant de la plaque 17 de fermeture sont interposés respectivement entre l'ouverture 15 du corps et la plaque 40 d'isolation, d'une part, et entre la plaque 40 d'isolation et la plaque 17 de fermeture d'autre part.

Au moins le joint 48 d'étanchéité qui est interposé entre la plaque d'isolation 40 et la plaque 17 de fermeture est déformable élastiquement en compression.

Ce joint 48 est d'une épaisseur "e" déterminée apte à délimiter entre la plaque d'isolation 40 et la plaque 17 de fermeture un jeu "J' susceptible d'absorber le déplacement de la plaque 17 de fermeture qui est solidaire de chaque premier conduit 20 soumis au gaz d'échappement, et dont la position est à ce titre susceptible de varier en fonction de l'élévation de température du premier conduit 20.

Ainsi, lorsque comme l'illustre la figure 3, le joint 48 est reçu dans une rainure 50 formée dans l'élément d'isolation, il sera compris que le jeu "J" sera déterminé par l'épaisseur "e" du joint dont sera retranchée la profondeur de la rainure 50.

Par ailleurs, le connecteur 36 comporte une partie 52 de liaison qui est agencée axialement entre la bague annulaire 32 de l'élément thermoélectrique 24P terminant axialement le module 18 et la partie intermédiaire 38 du connecteur 36, et qui est isolée du premier conduit 20 de gaz d'échappement par l'intermédiaire d'une couche d'air "C".

La partie de liaison 52 est tubulaire, et elle délimite radialement autour du premier conduit de gaz et axialement entre l'élément thermoélectrique 24P annulaire et la plaque 17 de fermeture une chambre isolante 54 remplie d'air, ou lame d'air, qui comporte la couche d'air "C" autour du premier conduit 20 et une épaisseur d'air définie par le jeu « J ».

Dans le mode de réalisation préféré de l'invention, le connecteur 36 est venu de matière avec la bague 32, ce qui signifie que la partie 52 de liaison du connecteur 36 est venue de matière avec la bague 32. Il sera compris que cette disposition n'est pas limitative de l'invention et que la partie 52 de liaison pourrait être soudée sur la bague 32.

Dans le mode de réalisation qui a été représenté à la figure 4, la face annulaire active de l'élément thermoélectrique 24P annulaire comportant une bague avec laquelle le connecteur 36 est venu de matière est une face annulaire extérieure 28 dudit élément thermoélectrique 24P. Cette configuration n'est pas limitative de l'invention, et la face annulaire active extérieure de l'élément thermoélectrique 24P annulaire comportant une bague avec laquelle le connecteur 36 est venu de matière pourrait être une face annulaire intérieure 26 dudit élément thermoélectrique 24P, pourvu que la partie de liaison 52 du connecteur 36 forme avec le premier conduit 20, en s'éloignant du premier conduit 20, un jeu suffisant (non représenté) pour délimiter une couche d'air "C" autour du premier conduit 20.

Tel qu'il a été représenté à la figure 4, la partie de liaison 52 du connecteur 36 est reçue dans un alésage complémentaire 54 de la plaque d'isolation 40, et elle s'étend au moins jusqu'à une face 56 de la plaque d'isolation 40 qui est tournée vers la plaque 17 de fermeture. On remarquera que la gaine 34 peut être interposée entre ledit alésage 54 et la partie de liaison 52 du connecteur.

De préférence, la plaque d'isolation 40 est réalisée en un matériau plastique isolant tel que notamment du polyamide 6.6. Ainsi, la partie intermédiaire 38 qui est de préférence soudée à la partie 52 de liaison, peut être noyée par surmoulage dans le matériau plastique de la plaque d'isolation 40.

La cosse 44 s'étendant radialement par rapport à l'axe "A" du premier conduit 20, celle-ci est de préférence réalisée venue de matière avec la partie intermédiaire 38.

La gaine 34 entourant le module thermoélectrique tubulaire 18, le connecteur 36 est isolé de surcroît de la chambre 22 de fluide de refroidissement par l'intermédiaire d'un joint annulaire 58 qui est interposé entre une face annulaire d'épaulement 60 formée à l'extrémité de ladite gaine 34 et la plaque d'isolation 40.

La configuration précédemment décrite peut être appliquée à différents types d'éléments de ligne d'échappement qui reprennent le principe général d'accouplement électrique des modules thermoélectriques représentés à la figure 1. En ce cas, le corps 11 du premier boîtier 12 reçoit dans la cavité 13 une pluralité de premiers conduits 20 et de modules thermoélectriques tubulaires 18 reliés suivant un accouplement électrique en série par leurs extrémités opposées, deux modules thermoélectriques 18 de début et de fin d'accouplement comportant chacun un connecteur à leur extrémité tournée vers la plaque 17 de fermeture, comme représenté aux figures 1 et 2.

Cette configuration trouve notamment à s'appliquer dans des premier et second modes de réalisation d'un élément 10 de ligne d'échappement intégrant par ailleurs un échangeur apte à refroidir les gaz d'échappement en vue de les réutiliser dans un circuit de recyclage de gaz échappement, plus connu sous le vocable d' "EGR" ou "Exhaust Gas Recycling".

Selon le premier mode de réalisation qui a été représenté à la figure 1, la plaque de fermeture 17 du premier boîtier 12 est traversée par des extrémités d'entrée 62 des premiers conduits 20 de gaz d'échappement et le corps du premier boîtier reçoit une pluralité de seconds conduits 64, qui sont agencés parallèlement aux premiers conduits 20, qui traversent la première chambre 22 de fluide de refroidissement, dont des extrémités d'entrée 66 sont reliées à des extrémités de sortie 68 des premiers conduits opposées 20 à la plaque de fermeture 17 par l'intermédiaire d'une chambre 70 de distribution de gaz d'échappement. Des extrémités 72 de sortie des seconds conduits 64 traversent la plaque 17 de fermeture.

Les seconds conduits 64 constituent ainsi un faisceau d'échangeur thermique permettant le refroidissement des gaz, pour leur utilisation dans le circuit de recyclage des gaz d'échappement.

Selon le second mode de réalisation qui a été représenté à la figure 2 la plaque 17 de fermeture du premier boîtier est seulement traversée par des extrémités d'entrée 62 des premiers conduits 20 de gaz d'échappement.

Le premier boîtier 12 est accouplé à son extrémité 74 qui est opposée à la plaque 17 de fermeture avec un second boîtier 76, illustré en partie, qui reçoit une pluralité de seconds conduits agencés au sein d'une seconde chambre de fluide de refroidissement.

Des extrémités d'entrée des seconds conduits sont reliées à des extrémités de sortie 68 des premiers conduits 20 qui sont opposées à la plaque de fermeture 17 du premier boîtier 12 par l'intermédiaire d'une chambre 76 intermédiaire de distribution de gaz d'échappement, et des extrémités de sortie desdits seconds conduits débouchent à une extrémité opposée 80 du second boîtier 76. De la même façon que précédemment, les seconds conduits constituant des échangeurs thermiques permettant le refroidissement des gaz d'échappement, notamment pour leur utilisation dans un circuit de recyclage des gaz d'échappement.

On remarquera que la chambre intermédiaire 78 de distribution de gaz d'échappement peut être formée dans un boîtier intermédiaire 82 qui est interposé entre les premier et second boîtiers 12, 76.

L'invention permet donc d'assurer de manière fiable le branchement électrique d'un élément de ligne d'échappement comportant des modules 18 thermoélectriques, et d'intégrer de manière simple des modules à un circuit de recyclage des gaz d'échappement.

## Revendications

1. Dispositif thermoélectrique comportant un premier circuit (14), parcouru par un premier fluide et destiné à être raccordé à une chambre de circulation du premier fluide, un second circuit (16) parcouru par un second fluide, et au moins un module (18) d'éléments thermoélectriques (24P, 24N) permettant la génération d'un courant électrique à partir d'un gradient de température appliqué entre des première et seconde faces actives (26, 28) desdits éléments thermoélectrique (24P, 24N), respectivement en relation d'échange thermique avec lesdits premier et second circuits, ledit second circuit (16) comportant au moins une chambre (22) de circulation du second fluide, ledit dispositif comportant en outre au moins un connecteur (36), relié électriquement audit module (18), pour permettre la connexion électrique dudit module (18) extérieurement audit dispositif, ledit connecteur (36) étant configuré pour passer entre lesdites chambres de circulation des premier et second fluides.

2. Dispositif selon la revendication 1 dans lequel ledit connecteur (36) traverse de manière étanche une paroi (40) de la chambre (22) de circulation du second fluide, ledit connecteur comprenant une partie intermédiaire (38), dite d'isolation, en contact avec une surface de ladite paroi, en dehors de ladite chambre de circulation (22) du second fluide.

3. Dispositif selon la revendication précédente comprenant une lame d'air (54) traversée par ladite partie d'isolation (38) pour l'isoler thermiquement de ladite chambre de circulation du premier fluide et/ou dudit premier circuit (14).

4. Dispositif selon l'une quelconque des revendications 2 ou 3 dans lequel :
- ledit premier circuit (14) comporte au moins un premier conduit (20) de circulation du premier fluide en relation d'échange thermique avec au moins l'une des premières faces (26) actives des éléments thermoélectriques (24P, 24N),
- ladite chambre de circulation (22) de circulation du second fluide est agencée autour du premier conduit (20), ladite chambre de circulation (22) du second fluide étant apte à permettre la circulation du second fluide en relation d'échange thermique avec la seconde face active (28) des éléments thermoélectriques (24P, 24N).

5. Dispositif selon la revendication précédente, comprenant au moins un premier boîtier (12) comprenant un corps (11) comportant au moins une cavité (13) orientée sensiblement suivant une direction axiale (A) du premier conduit, ledit corps (11) recevant la chambre (22) de circulation du second fluide et entourant le premier conduit (20), ledit corps (11) comportant une ouverture (15), fermée de manière étanche par une plaque (17) de fermeture du boîtier (12), ladite plaque (17) étant traversée par le premier conduit (20), la paroi (40) de la chambre de circulation (22) du second fluide comprenant une plaque d'isolation qui est pincée entre un pourtour de l'ouverture (15) du corps (11) et la plaque (17) de fermeture, ladite plaque d'isolation (40) recevant au moins une partie de la partie intermédiaire (38) du connecteur (36) dans son épaisseur (42).

6. Dispositif selon la revendication précédente, dans lequel des joints d'étanchéité (46, 48) correspondants au pourtour de l'ouverture (15) du corps (11) et à un pourtour correspondant de la plaque (17) de fermeture sont interposés entre l'ouverture (15) du corps (12) et la plaque (40) d'isolation d'une part et entre la plaque (40) d'isolation et la plaque (17) de fermeture d'autre part.

7. Dispositif selon la revendication précédente, dans lequel au moins le joint d'étanchéité (48) entre la plaque d'isolation (40) et la plaque (17) de fermeture est déformable élastiquement en compression, ledit joint étant d'une épaisseur (e) déterminée pour délimiter entre la plaque d'isolation (40) et la plaque (17) de fermeture un jeu (J) apte à absorber la dilatation de chaque premier conduit (20).

8. Dispositif selon l'une quelconque des revendications 5 à 7 dans lequel :
- lesdits éléments thermoélectriques (24P, 24N) sont annulaires et ledit module (18) est tubulaire,
- ledit connecteur (36) est relié électriquement à au moins une bague (32) annulaire du module (18), ladite bague permettant la conduction du courant électrique généré par le module.

9. Dispositif selon la revendication précédente dans lequel le connecteur (36) comporte une partie (52) de liaison qui est agencée axialement entre la bague annulaire (32) et la partie intermédiaire (38) du connecteur (36), et qui est isolée du premier conduit (20) par l'intermédiaire d'une couche (C) d'air.

10. Dispositif selon la revendication précédente, dans lequel la partie de liaison (52) est tubulaire et elle délimite radialement autour du premier conduit (20) et axialement entre l'un des éléments thermoélectriques (3) terminant axialement le module (18) et la plaque de fermeture une chambre (54) isolante remplie d'air comportant la couche (C) d'air.

11. Dispositif selon la revendication précédente, dans lequel la bague annulaire (32) du module (18) est située au niveau d'une face annulaire extérieure (28) dudit élément thermoélectrique (24P) terminant axialement ledit module, la partie (52) de liaison du connecteur (36) est reçue dans un alésage complémentaire (54) de la plaque d'isolation (40), et elle s'étend au moins jusqu'à une face (56) de la plaque d'isolation (40) tournée vers la plaque (17) de fermeture.

12. Dispositif selon l'une quelconque des revendications 9 à 11, dans lequel la plaque d'isolation (40) est réalisée en un matériau plastique, notamment du polyamide 6.6, et la partie intermédiaire (38), soudée à la partie de liaison (52), est au moins partiellement noyée par surmoulage dans le matériau plastique de la plaque d'isolation (40).

13. Dispositif selon l'une quelconque des revendications 5 à 12 dans lequel ledit connecteur (36) comporte au moins une cosse faisant saillie hors du premier boîtier (12) pour permettre la connexion électrique dudit module (18) extérieurement au premier boîtier (12), ladite cosse (44) étant venue de matière avec la partie intermédiaire (38).

14. Dispositif selon l'une des revendications précédentes comprenant une pluralité de dits modules (18) reliés suivant un accouplement électrique en série, deux modules thermoélectriques (18) de début et de fin d'accouplement comportant chacun un dit connecteur (36) à l'une de leur extrémité, destinée à être tournée vers ladite chambre de circulation du premier fluide.

15. Elément (10) de ligne d'échappement d'un véhicule automobile comprenant un dispositif selon l'une quelconque des revendications précédentes, ledit premier fluide étant formé de gaz d'échappement, notamment de gaz d'échappement recirculés.
